# EUROPEAN PATENT APPLICATION

(11) **EP 4 657 763 A1**
(43) Date of publication of application: **03.12.2025**
(21) Application number: 23920857.2
(22) Date of filing: 04.12.2023
(51) Int. Cl.: H04B 7/005, H04B 1/40

(54) **RADIO FREQUENCY MODULE, ANTENNA APPARATUS, AND COMMUNICATION DEVICE**

(30) Priority: 10.02.2023 CN 202310144196
(71) Applicant: Huawei Technologies Co., Ltd., Shenzhen, Guangdong 518129 (CN)
(72) Inventor: WEI, Xiaodong, Shenzhen, Guangdong 518129 (CN); XIAO, Weihong, Shenzhen, Guangdong 518129 (CN); PENG, Zhongwei, Shenzhen, Guangdong 518129 (CN); PU, Tao, Shenzhen, Guangdong 518129 (CN)
(74) Representative: Goddar, Heinz J.
(86) International application number: PCT/CN2023/136125
(87) International publication number: WO 2024/164668

(57) **Abstract**

Embodiments of this application disclose a radio frequency module, an antenna apparatus, and a communication device, to implement integration of switch, phase-shift, and power division functions. The radio frequency module provided in this application includes a power division network, a first branch circuit, and a second branch circuit. The first branch circuit includes an impedance adjustment network and a first radio frequency output port, and the second branch circuit includes a phase-shift filtering network and a second radio frequency output port. The power division network is connected to a radio frequency output end, the first branch circuit, and the second branch circuit. The impedance adjustment network is configured to adjust impedance of the first branch circuit based on power of the first branch circuit. The phase-shift filtering network is configured to control an output status of the second branch circuit and a phase of an output signal of the second branch circuit, where the output status indicates whether the second branch circuit outputs a signal.

## Description

This application claims priority to Chinese Patent Application No. CN202310144196.0, filed with the China National Intellectual Property Administration on February 10, 2023 and entitled "RADIO FREQUENCY MODULE, ANTENNA APPARATUS, AND COMMUNICATION DEVICE", which is incorporated herein by reference in its entirety.

### TECHNICAL FIELD

This application relates to the communication field, and in particular, to a radio frequency module, an antenna apparatus, and a communication device.

### BACKGROUND

With development of communication technologies, circuit functions of a radio frequency front-end are increasingly diversified. The circuit functions include a switch function, a power division function, a phase-shift function, and the like. These functions play important roles at the radio frequency front-end. In consideration of integration, how to implement a plurality of circuit functions in one radio frequency module is extremely important in future development of communication technologies.

In a radio frequency module, two levels of radio frequency transmission lines connected in series are loaded to the ground through a diode, to implement selection of a transmit path and a receive path. In such a radio frequency module, only a switch function is implemented in the radio frequency module, and a power division or phase-shift function cannot be implemented, and a component has a single function.

### SUMMARY

This application provides a radio frequency module, an antenna apparatus, and a related device. A power division network is configured to allocate power of each branch circuit, and an impedance adjustment network adjusts impedance of a first branch circuit based on power that is of the first branch circuit and that is allocated by the power division network, to jointly implement a power division function. A phase-shift filtering network can control an output status of a second branch circuit to implement a switch function, and can also adjust a phase of an output signal of the second branch circuit to implement a phase-shift function. In other words, the radio frequency module provided in this application implements integration of switch, phase-shift, and power division functions, and the radio frequency module has diversified functions.

A first aspect of this application provides a radio frequency module, including a power division network, a first branch circuit, and a second branch circuit. The first branch circuit includes an impedance adjustment network and a first radio frequency output port, and the second branch circuit includes a phase-shift filtering network and a second radio frequency output port. A radio frequency signal enters the radio frequency module through a radio frequency input port, a radio frequency input end is connected to the power division network, and the power division network is further connected to the first branch circuit and the second branch circuit. In other words, the power division network is located on a main circuit of the radio frequency module, and both the impedance adjustment network and the phase-shift filtering network are located on branch circuits of the radio frequency module. The power division network is configured to determine power of the first branch circuit and power of the second branch circuit. A specific determining manner may be allocating the power of the two branch circuits based on a preset power division ratio or preset power, or may be another manner. This is not specifically limited herein. The impedance adjustment network is configured to adjust impedance of the first branch circuit based on the power of the first branch circuit, so that the impedance of the first branch circuit matches the power of the first branch circuit. The phase-shift filtering network is configured to control an output status of the second branch circuit and a phase of an output signal of the second branch circuit. The output status of the second branch circuit indicates whether the second branch circuit outputs a signal.

In this application, the radio frequency module includes the power division network, the impedance adjustment network, and the phase-shift filtering network. The power division network is configured to allocate power of each branch circuit, and the impedance adjustment network adjusts the impedance of the first branch circuit based on the power that is of the first branch circuit and that is allocated by the power division network, to jointly implement a power division function. The phase-shift filtering network can control the output status of the second branch circuit to implement a switch function, and can also adjust the phase of the output signal of the second branch circuit to implement a phase-shift function. In other words, the radio frequency module provided in this application implements integration of switch, phase-shift, and power division functions, and the radio frequency module has diversified functions.

In a possible implementation of the first aspect, the impedance adjustment network is specifically configured to: when the second radio frequency output port outputs no signal, adjust the impedance of the first branch circuit to first impedance; and when the second radio frequency output port outputs a signal, adjust the impedance of the first branch circuit to second impedance. The second impedance is greater than the first impedance. To be specific, the first impedance of the first branch circuit in a case in which the phase-shift filtering network is in a filtering state (a state in which the second radio frequency output port is controlled to output no signal) is less than the second impedance of the first branch circuit in a case in which the phase-shift filtering network is in a phase-shift state (a state in which the second radio frequency output port is controlled to output a signal).

In this application, the impedance adjustment network and the phase-shift filtering network cooperate with each other, so that impedance of the branch circuit matches impedance of the main circuit. This ensures that the radio frequency module can normally work, and improves implementability and practicability of the technical solutions of this application.

In a possible implementation of the first aspect, the phase-shift filtering network includes a bridge and two first adjustment submodules. An input end of the bridge is connected to the power division network, and three output ends of the bridge are respectively connected to the two first adjustment submodules and the second radio frequency output port. The two first adjustment submodules are configured to control whether the second radio frequency output port outputs a signal and a phase of an output signal of the second radio frequency output port.

In a possible implementation of the first aspect, there are a plurality of possibilities for the bridge included in the phase-shift filtering network. The bridge may be a 90° bridge, or may be a 180° bridge. When the bridge is a 180° bridge, if the two first adjustment submodules are in a same on/off state, the second radio frequency output port outputs no signal; and if the two first adjustment submodules are in different on/off states, the second radio frequency output port outputs a signal. When the bridge is a 90° bridge, if the two first adjustment submodules are in different on/off states, the second radio frequency output port outputs no signal; and if the two first adjustment submodules are in a same on/off state, the second radio frequency output port outputs a signal.

In this application, the bridge included in the phase-shift filtering network has a plurality of forms. This enriches implementations of the technical solutions of this application. In addition, in different bridge forms, the two first adjustment submodules configured to determine whether the second radio frequency module outputs a signal are in different on/off states. This is adapted to a change of the bridge.

In a possible implementation of the first aspect, each of the two first adjustment submodules includes a first adjustment stub, a first diode, a first capacitor, a first inductor, and a first control end. The first adjustment stub, the first diode, and the first capacitor are sequentially connected, the first adjustment stub is connected to an output end of the bridge, and the first capacitor is grounded. The first diode is connected to the first inductor, and the first inductor is connected to the first control end. The first control end is configured to control an on/off state of the first diode. On/off of the first diode is controlled to adjust an on/off state of the first adjustment submodule.

In a possible implementation of the first aspect, each of the two first adjustment submodules may alternatively include other components, for example, include a first adjustment stub, a first electric control component, and a first control end that are sequentially connected. The first electric control component is grounded, and the first control end is configured to control an on/off state of the first electric control component. The first electric control component includes a micro-electro-mechanical systems (micro-electro-mechanical systems, MEMS) switch, a monolithic tube, or another component having a switch function. This is not specifically limited herein.

In this application, there are a plurality of possibilities for components included in the first adjustment submodule and a connection relationship between the components, so that different requirements can be met. This improves flexibility and practicability of the technical solutions of this application.

In a possible implementation of the first aspect, the impedance adjustment network includes a second diode, a second adjustment stub, a second capacitor, a second inductor, and a second control end. The second diode, the second adjustment stub, and the second capacitor are sequentially connected, the second diode is connected to the power division network and the first radio frequency output port, and the second capacitor is grounded. The second adjustment stub is connected to the second inductor, and the second inductor is connected to the second control end. In other words, the impedance adjustment network may be connected to a circuit in a form of a short-circuit stub. The second control end is configured to control on/off of the second diode. Impedance of the impedance adjustment network in a case in which the second diode is turned on is greater than impedance of the impedance adjustment network in a case in which the second diode is turned off.

In a possible implementation of the first aspect, the impedance adjustment network includes a second electric control component, a third control end, and a second adjustment stub. The second electric control component is connected to the power division network, the first radio frequency output port, the third control end, and the second adjustment stub, and the second adjustment stub is grounded. The third control end is configured to control on/off of the second electric control component. Impedance of the impedance adjustment network in a case in which the second electric control component is turned on is greater than impedance of the impedance adjustment network in a case in which the second electric control component is turned off. The second electric control component includes an MEMS switch, a monolithic tube, or another component having a switch function. This is not specifically limited herein.

In this application, there are a plurality of possibilities for components included in the impedance adjustment network and a connection relationship between the components, so that different requirements can be met. This improves flexibility and practicability of the technical solutions of this application.

In a possible implementation of the first aspect, the phase-shift filtering network includes a filtering subnetwork and a phase-shift subnetwork. The power division network is connected to the filtering subnetwork and the phase-shift subnetwork, and the phase-shift subnetwork is connected to the second radio frequency output port. When the filtering subnetwork is turned off, the phase-shift filtering network performs a phase-shift function, and the second radio frequency output port outputs a signal; and when the filtering subnetwork is turned on, the phase-shift filtering network performs a filtering function, and the second radio frequency output port outputs no signal.

In this application, the phase-shift filtering network may alternatively include an independent filtering subnetwork and an independent phase-shift subnetwork, to implement filtering and phase-shift functions through cooperation between the two subnetworks.

In a possible implementation of the first aspect, the filtering subnetwork includes a third adjustment stub, a third diode, a third capacitor, a third inductor, and a fourth control end. The third adjustment stub, the third diode, and the third capacitor are sequentially connected, the third adjustment stub is connected to the power division network, and the third capacitor is grounded. The third diode is connected to the third inductor, and the third inductor is connected to the fourth control end. The fourth control end is configured to control an on/off state of the third diode.

In a possible implementation of the first aspect, the phase-shift subnetwork includes a 90° bridge, two second adjustment submodules, and a fifth control end. An input end of the 90° bridge is connected to the filtering subnetwork and the power division network, and three output ends of the 90° bridge are respectively connected to the two second adjustment submodules and the second radio frequency output port. The fifth control end is configured to control on/off states of the two second adjustment submodules.

A second aspect of embodiments of this application provides a radio frequency module, including an impedance adjustment network, a power division network, a first branch circuit, and a second branch circuit. The first branch circuit includes a first radio frequency output port, and the second branch circuit includes a phase-shift filtering network and a second radio frequency output port. A radio frequency input end is connected to the impedance adjustment network and the power division network, the power division network is further connected to the first radio frequency output port and the phase-shift filtering network, and the phase-shift filtering network is connected to the second radio frequency output port. In other words, the impedance adjustment network and the power division network are located on a main circuit of the radio frequency module, and the phase-shift filtering network is located on a branch circuit of the radio frequency module. The impedance adjustment network and the power division network are jointly configured to adjust first power of the first branch circuit and second power of the second branch circuit. The phase-shift filtering network is configured to control an output status of the second branch circuit and a phase of an output signal of the second branch circuit. The output status of the second branch circuit indicates whether the second branch circuit outputs a signal.

In this application, the power division network and the impedance adjustment network are jointly configured to allocate power of each branch circuit to implement a power division function. The phase-shift filtering network can control the output status of the second branch circuit to implement a switch function, and can also adjust the phase of the output signal of the second branch circuit to implement a phase-shift function. In other words, the radio frequency module provided in this application implements integration of switch, phase-shift, and power division functions, and the radio frequency module has diversified functions.

In a possible implementation of the second aspect, the impedance adjustment network is specifically configured to: if the second radio frequency output port outputs no signal, adjust impedance of the impedance adjustment network to first impedance; and if the second radio frequency output port outputs a signal, adjust impedance of the impedance adjustment network to second impedance, where the second impedance is greater than the first impedance.

In this application, the impedance adjustment network and the phase-shift filtering network cooperate with each other, so that impedance of the branch circuit matches impedance of the main circuit. This ensures that the radio frequency module can normally work, and improves implementability and practicability of the technical solutions of this application.

In a possible implementation of the second aspect, the phase-shift filtering network includes a bridge and two first adjustment submodules. An input end of the bridge is connected to the power division network, and three output ends of the bridge are respectively connected to the two first adjustment submodules and the second radio frequency output port. The two first adjustment submodules are configured to control whether the second radio frequency output port outputs a signal and a phase of an output signal of the second radio frequency output port.

In a possible implementation of the second aspect, if the bridge is a 180° bridge, when the two first adjustment submodules are in a same on/off state, the second radio frequency output port outputs no signal; and when the two first adjustment submodules are in different on/off states, the second radio frequency output port outputs a signal. If the bridge is a 90° bridge, when the two first adjustment submodules are in different on/off states, the second radio frequency output port outputs no signal; and when the two first adjustment submodules are in a same on/off state, the second radio frequency output port outputs a signal.

In this application, the bridge included in the phase-shift filtering network has a plurality of forms. This enriches implementations of the technical solutions of this application. In addition, in different bridge forms, the two first adjustment submodules configured to determine whether the second radio frequency module outputs a signal are in different on/off states. This is adapted to a change of the bridge.

In a possible implementation of the second aspect, each of the two first adjustment submodules includes a first adjustment stub, a first diode, a first capacitor, a first inductor, and a first control end. The first adjustment stub, the first diode, and the first capacitor are sequentially connected, the first adjustment stub is connected to an output end of the bridge, and the first capacitor is grounded. The first diode is connected to the first inductor, and the first inductor is connected to the first control end. The first control end is configured to control an on/off state of the first diode.

In a possible implementation of the second aspect, each of the two first adjustment submodules includes a first adjustment stub, a first electric control component, and a first control end that are sequentially connected. The first electric control component is grounded, and the first control end is configured to control an on/off state of the first electric control component. The first electric control component includes an MEMS switch, a monolithic tube, or another component having a switch function. This is not specifically limited herein.

In this application, there are a plurality of possibilities for components included in the first adjustment submodule and a connection relationship between the components, so that different requirements can be met. This improves flexibility and practicability of the technical solutions of this application.

In a possible implementation of the second aspect, the impedance adjustment network includes a second diode, a second adjustment stub, a second capacitor, a second inductor, and a second control end. The second diode, the second adjustment stub, and the second capacitor are sequentially connected, the second diode is connected to the power division network and the first radio frequency output port, and the second capacitor is grounded. The second adjustment stub is connected to the second inductor, and the second inductor is connected to the second control end. The second control end is configured to control on/off of the second diode. Impedance of the impedance adjustment network in a case in which the second diode is turned on is greater than impedance of the impedance adjustment network in a case in which the second diode is turned off.

In a possible implementation of the second aspect, the impedance adjustment network includes a second electric control component, a third control end, and a second adjustment stub. The second electric control component is connected to the power division network, the first radio frequency output port, the third control end, and the second adjustment stub, and the second adjustment stub is grounded. The third control end is configured to control on/off of the second electric control component. Impedance of the impedance adjustment network in a case in which the second electric control component is turned on is greater than impedance of the impedance adjustment network in a case in which the second electric control component is turned off. The second electric control component includes an MEMS switch, a monolithic tube, or another component having a switch function. This is not specifically limited herein.

In this application, there are a plurality of possibilities for components included in the impedance adjustment network and a connection relationship between the components, so that different requirements can be met. This improves flexibility and practicability of the technical solutions of this application.

In a possible implementation of the second aspect, the phase-shift filtering network includes a filtering subnetwork and a phase-shift subnetwork. The power division network is connected to the filtering subnetwork and the phase-shift subnetwork, and the phase-shift subnetwork is connected to the second radio frequency output port. When the filtering subnetwork is turned off, the phase-shift filtering network performs a phase-shift function, and the second radio frequency output port outputs a signal; and when the filtering subnetwork is turned on, the phase-shift filtering network performs a filtering function, and the second radio frequency output port outputs no signal.

In this application, the phase-shift filtering network may alternatively include an independent filtering subnetwork and an independent phase-shift subnetwork, to implement filtering and phase-shift functions through cooperation between the two subnetworks.

In a possible implementation of the second aspect, the filtering subnetwork includes a third adjustment stub, a third diode, a third capacitor, a third inductor, and a fourth control end. The third adjustment stub, the third diode, and the third capacitor are sequentially connected, the third adjustment stub is connected to the power division network, and the third capacitor is grounded. The third diode is connected to the third inductor, and the third inductor is connected to the fourth control end. The fourth control end is configured to control an on/off state of the third diode.

In a possible implementation of the second aspect, the phase-shift subnetwork includes a 90° bridge, two second adjustment submodules, and a fifth control end. An input end of the 90° bridge is connected to the filtering subnetwork and the power division network, and three output ends of the 90° bridge are respectively connected to the two second adjustment submodules and the second radio frequency output port. The fifth control end is configured to control on/off states of the two second adjustment submodules.

A third aspect of this application provides an antenna apparatus, including a feeding network. The feeding network includes the radio frequency module in any one of the first aspect and the implementations of the first aspect or any one of the second aspect and the implementations of the second aspect.

A fourth aspect of this application provides a communication device, including the antenna apparatus in the third aspect. The communication device may be a base station, a terminal device, or a remote radio unit (remote radio unit, RRU). This is not specifically limited herein.

Beneficial effects in the third aspect and the fourth aspect are similar to beneficial effects in any one of the first aspect and the implementations of the first aspect or any one of the second aspect and the implementations of the second aspect. Details are not described herein.

### BRIEF DESCRIPTION OF DRAWINGS

FIG. 1 is a diagram of a system architecture according to an embodiment of this application;
FIG. 2a is a diagram of a structure of a radio frequency module according to an embodiment of this application;
FIG. 2b is a diagram of another structure of a radio frequency module according to an embodiment of this application;
FIG. 3a is a diagram of another structure of a radio frequency module according to an embodiment of this application;
FIG. 3b is a diagram of another structure of a radio frequency module according to an embodiment of this application;
FIG. 4a is a diagram of another structure of a radio frequency module according to an embodiment of this application;
FIG. 4b is a diagram of another structure of a radio frequency module according to an embodiment of this application;
FIG. 4c is a diagram of another structure of a radio frequency module according to an embodiment of this application;
FIG. 5a is a diagram of another structure of a radio frequency module according to an embodiment of this application;
FIG. 5b is a diagram of another structure of a radio frequency module according to an embodiment of this application;
FIG. 6a is a diagram of another structure of a radio frequency module according to an embodiment of this application;
FIG. 6b is a diagram of another structure of a radio frequency module according to an embodiment of this application;
FIG. 7 is a diagram of another structure of a radio frequency module according to an embodiment of this application;
FIG. 8a is a diagram of another structure of a radio frequency module according to an embodiment of this application;
FIG. 8b is a diagram of another structure of a radio frequency module according to an embodiment of this application;
FIG. 9a is a diagram of another structure of a radio frequency module according to an embodiment of this application;
FIG. 9b is a diagram of another structure of a radio frequency module according to an embodiment of this application;
FIG. 10 is a diagram of another structure of a radio frequency module according to an embodiment of this application;
FIG. 11a is a diagram of another structure of a radio frequency module according to an embodiment of this application;
FIG. 11b is a diagram of another structure of a radio frequency module according to an embodiment of this application;
FIG. 12 is a diagram of another structure of a radio frequency module according to an embodiment of this application;
FIG. 13 is a diagram of another structure of a radio frequency module according to an embodiment of this application;
FIG. 14 is a diagram of a structure of an antenna apparatus according to an embodiment of this application; and
FIG. 15 is a diagram of another structure of a communication device according to an embodiment of this application.

### DESCRIPTION OF EMBODIMENTS

This application provides a radio frequency module, an antenna apparatus, and a related device. The radio frequency module includes a power division network, an impedance adjustment network, and a phase-shift filtering network. The power division network is configured to allocate power of each branch circuit, and the impedance adjustment network adjusts impedance of a first branch circuit based on power that is of the first branch circuit and that is allocated by the power division network, to jointly implement a power division function. The phase-shift filtering network can control an output status of a second branch circuit to implement a switch function, and can also adjust a phase of an output signal of the second branch circuit to implement a phase-shift function. In other words, the radio frequency module provided in this application implements integration of switch, phase-shift, and power division functions, and the radio frequency module has diversified functions.

The following describes embodiments of this application with reference to the accompanying drawings. A person of ordinary skill in the art may learn that, with development of technologies and emergence of new scenarios, the technical solutions provided in embodiments of this application are also applicable to a similar technical problem.

In the specification, claims, and accompanying drawings of this application, the terms such as "first" and "second" are intended to distinguish between similar objects but are not necessarily intended to describe a specific order or sequence. It should be understood that the terms used in such a way are interchangeable in proper circumstances, and this is merely a distinguishing manner used when objects with a same attribute are described in embodiments of this application. In addition, the terms "include", "have", and any other variants thereof are intended to cover non-exclusive inclusion, so that a process, method, system, product, or device that includes a series of units is not necessarily limited to those units, but may include other units not expressly listed or inherent to such a process, method, product, or device. In addition, "at least one" means one or more, and "a plurality of" means two or more. The term "and/or" describes an association relationship between associated objects and indicates that three relationships may exist. For example, A and/or B may indicate the following cases: Only A exists, both A and B exist, and only B exists, where A and B may be singular or plural. The character "/" generally indicates an "or" relationship between the associated objects. The expression "at least one of the following items (pieces)" or a similar expression thereof indicates any combination of these items, including a single item (piece) or any combination of a plurality of items (pieces). For example, at least one of a, b, or c may indicate a, b, c, a and b, a and c, b and c, or a, b, and c, where a, b, and c may be singular or plural.

The radio frequency module provided in embodiments of this application may be used in a communication device, for example, used in an antenna of a base station, or used in a radio frequency link. This is not specifically limited herein.

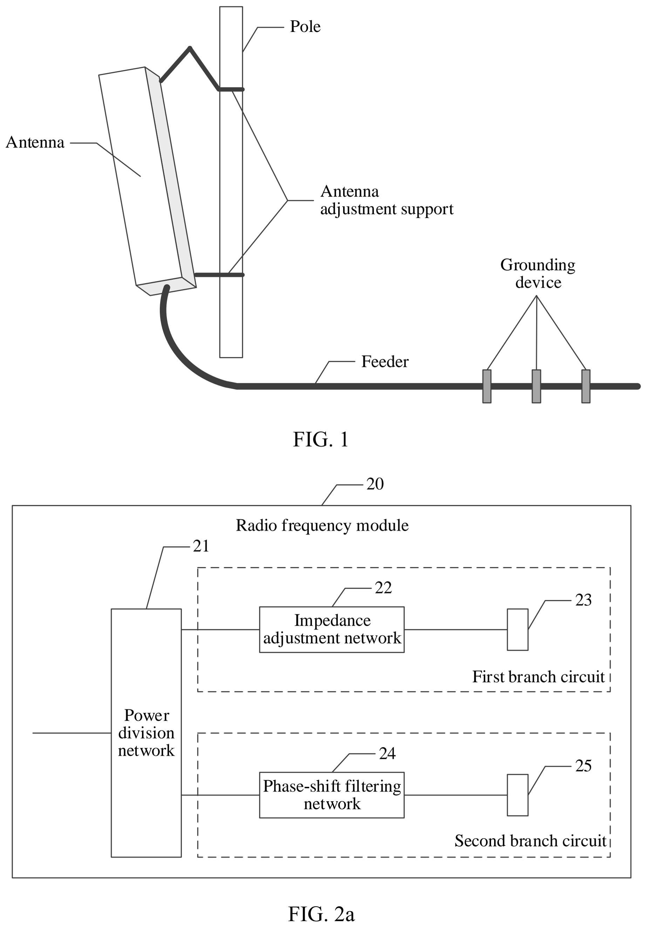

For example, an antenna feeder system of a base station is used as an example to briefly describe a system architecture in embodiments of this application. FIG. 1 is a diagram of a system architecture according to an embodiment of this application.

As shown in FIG. 1, the antenna feeder system of the base station includes an antenna, a feeder, a pole, and an antenna adjustment support. In some optional implementations, the antenna feeder system of the base station further includes a grounding device. The pole and the antenna adjustment support are configured to determine and fasten the antenna and adjust a position of the antenna. The antenna is a device configured to radiate and receive radio waves, and can implement mutual conversion between a current and an electromagnetic wave. As a part of a feeding network, the feeder can transmit an electromagnetic wave from a transmitter to the antenna or from the antenna to a receiver at a minimized loss. The radio frequency module provided in embodiments of this application may be placed in the feeding network of the antenna of the base station, to implement function switchover and modulation of a beam width and a beam direction, and also integrate switch, phase-shift, and power division functions.

The following describes the radio frequency module provided in embodiments of this application. In general, the radio frequency module includes a power division network, an impedance adjustment network, and a phase-shift filtering network. The impedance adjustment network may be located on a main circuit, or may be located on a branch circuit. Based on this, radio frequency modules may be classified as a main circuit matching mode and a branch circuit matching mode. In the following descriptions, different types of radio frequency modules are separately described based on the classification reference.
I. Radio frequency module in a branch circuit matching mode.

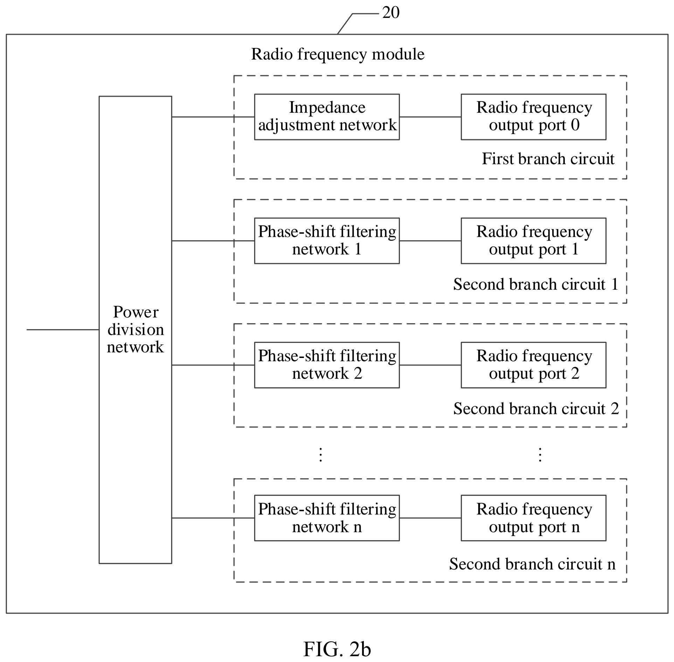

FIG. 2a and FIG. 2b each are a diagram of a structure of a radio frequency module according to an embodiment of this application.

As shown in FIG. 2a, a radio frequency module 20 includes a power division network 21, a first branch circuit, and a second branch circuit. The first branch circuit includes an impedance adjustment network 22 and a first radio frequency output port 23, and the second branch circuit includes a phase-shift filtering network 24 and a second radio frequency output port 25. It should be noted that, a radio frequency signal from the outside of the radio frequency module enters the power division network 21 in the radio frequency module 20 through a radio frequency input port and a radio frequency transmission line. In an embodiment shown in FIG. 2a, the radio frequency input port is not shown, and a line that is at a leftmost end and that is connected to the power division network 21 in FIG. 2a represents the radio frequency transmission line. Optionally, the radio frequency module 20 may include the radio frequency input port, and the radio frequency input port is connected to the radio frequency transmission line at the leftmost end in FIG. 2a. To be specific, the radio frequency signal enters the radio frequency module 20 through the radio frequency input port, and is divided into two signals after being processed by the power division network 21, and the two signals respectively enter the first branch circuit and the second branch circuit. It should be noted that, an example in which the radio frequency module 20 does not include the radio frequency input port is used in all the following descriptions.

The power division network 21 is configured to determine power of the first branch circuit and power of the second branch circuit. A specific determining manner may be allocating the power of the two branch circuits based on a preset power division ratio or preset power, or may be another manner. This is not specifically limited herein. The impedance adjustment network 22 is configured to adjust impedance of the first branch circuit based on the power of the first branch circuit, so that the impedance of the first branch circuit matches the power of the first branch circuit. The phase-shift filtering network 24 is configured to control an output status of the second branch circuit and a phase of an output signal of the second branch circuit. The output status of the second branch circuit indicates whether the second branch circuit outputs a signal, in other words, whether the second radio frequency output port 25 outputs a signal.

It should be noted that, FIG. 2a shows an example in which the radio frequency module 20 includes one first branch circuit and one second branch circuit. In actual application, the radio frequency module 20 may alternatively include more second branch circuits. This is not specifically limited herein. In other words, the radio frequency module 20 provided in this application includes a two-output circuit structure, and may alternatively have more outputs. This enriches application scenarios of the radio frequency module 20, and improves practicability of the technical solutions of this application.

For example, as shown in FIG. 2b, a radio frequency module 20 includes one first branch circuit and n second branch circuits, where n≥3. The first branch circuit includes an impedance adjustment network and a radio frequency output port 0, and each second branch circuit includes one phase-shift filtering network and one radio frequency output port. For a structure in which the radio frequency module 20 includes a plurality of second branch circuits, a power division network is configured to determine power of the first branch circuit and power of each second branch circuit. The impedance adjustment network is configured to adjust impedance of the first branch circuit based on the power of the first branch circuit, so that the impedance of the first branch circuit matches the power of the first branch circuit. Each phase-shift filtering network is configured to control an output status of a second branch circuit on which the phase-shift filtering network is located and a phase of an output signal of the second branch circuit.

It should be noted that, in this embodiment of this application, the radio frequency input/output port of the radio frequency module has a direct current isolation feature. Details are not described herein.

In this embodiment of this application, the radio frequency module includes the power division network, the impedance adjustment network, and the phase-shift filtering network. The power division network is configured to allocate power of each branch circuit, and the impedance adjustment network adjusts the impedance of the first branch circuit based on the power that is of the first branch circuit and that is allocated by the power division network, to jointly implement a power division function. The phase-shift filtering network can control the output status of the second branch circuit to implement a switch function, and can also adjust the phase of the output signal of the second branch circuit to implement a phase-shift function. In other words, the radio frequency module provided in this application implements integration of switch, phase-shift, and power division functions, and the radio frequency module has diversified functions.

In this embodiment of this application, the impedance adjustment network and the phase-shift filtering network cooperate with each other in terms of working modes. Specifically, when the second radio frequency output port outputs no signal, the impedance adjustment network adjusts the impedance of the first branch circuit to first impedance; and when the second radio frequency output port outputs a signal, adjusts the impedance of the first branch circuit to second impedance. The second impedance is greater than the first impedance. To be specific, the first impedance of the first branch circuit in a case in which the phase-shift filtering network is in a filtering state (a state in which the phase-shift filtering network controls the second radio frequency output port to output no signal) is less than the second impedance of the first branch circuit in a case in which the phase-shift filtering network is in a phase-shift state (a state in which the phase-shift filtering network controls the second radio frequency output port to output a signal). In addition, it should be further noted that, when the phase-shift filtering network is in the filtering state, that the second radio frequency output port outputs no signal may also be understood as that a signal output channel of the second branch circuit is closed, and a switch function is implemented.

In this application, the impedance adjustment network and the phase-shift filtering network cooperate with each other, so that impedance of the branch circuit matches impedance of the main circuit. This ensures that the radio frequency module can normally work, and improves implementability and practicability of the technical solutions of this application.

For brevity of description, an example in which the radio frequency module includes one first branch circuit and one second branch circuit is used in all the following descriptions of the radio frequency module of the branch circuit matching mode type.

First, the phase-shift filtering network included in the radio frequency module is described. In this embodiment of this application, there are a plurality of possibilities for a structure of the phase-shift filtering network. The phase-shift filtering network may include a bridge and two first adjustment submodules, or may include a filtering subnetwork and a phase-shift subnetwork. The following separately describes possible structures.
1. The phase-shift filtering network includes a bridge and two first adjustment submodules.

In some optional implementations, the phase-shift filtering network includes a bridge and two first adjustment submodules. In general, an input end of the bridge is connected to the power division network, and three output ends of the bridge are respectively connected to the two first adjustment submodules and the second radio frequency output port. The two first adjustment submodules are configured to control whether the second radio frequency output port outputs a signal and a phase of an output signal of the second radio frequency output port.

Different types of bridges correspond to different control principles. In general, when the bridge is a 180° bridge, if the two first adjustment submodules are in a same on/off state, the second radio frequency output port outputs no signal; and if the two first adjustment submodules are in different on/off states, the second radio frequency output port outputs a signal. When the bridge is a 90° bridge, if the two first adjustment submodules are in different on/off states, the second radio frequency output port outputs no signal; and if the two first adjustment submodules are in a same on/off state, the second radio frequency output port outputs a signal.

In this application, the bridge included in the phase-shift filtering network has a plurality of forms. This enriches implementations of the technical solutions of this application. In addition, in different bridge forms, the two first adjustment submodules configured to determine whether the second radio frequency module outputs a signal are in different on/off states. This is adapted to a change of the bridge.

The following separately describes structures of the 180° bridge and the 90° bridge with reference to diagrams.

### 1.1. The bridge is a 180° bridge.

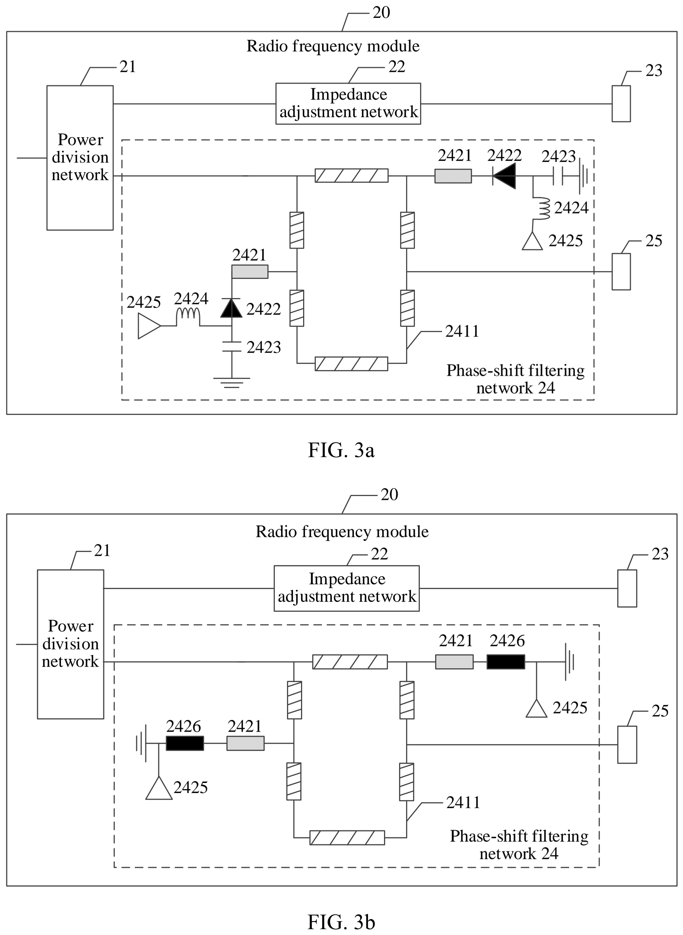

FIG. 3a and FIG. 3b each are a diagram of a structure of a radio frequency module according to an embodiment of this application.

In an embodiment shown in FIG. 3a, a bridge 2411 is a 180° bridge. Each of the two first adjustment submodules includes a first adjustment stub 2421, a first diode 2422, a first capacitor 2423, a first inductor 2424, and a first control end 2425. The first adjustment stub 2421 is actually a radio frequency transmission line, and a wavelength of the radio frequency transmission line may be determined based on an actual application requirement. This is not specifically limited herein.

The first adjustment stub 2421, the first diode 2422, and the first capacitor 2423 are sequentially connected, the first adjustment stub 2421 is connected to an output end of the bridge 2411, and the first capacitor 2423 is grounded. The first diode 2422 is further connected to the first inductor 2424, and the first inductor 2424 is connected to the first control end 2425.

The first control end 2425 is configured to control an on/off state of the first diode 2422. On/off of the first diode 2422 is controlled to adjust an on/off state of the first adjustment submodule. To be specific, if the first diode 2422 is turned off, it is considered that the first adjustment submodule is turned off; and if the first diode 2422 is cut off, it is considered that the first adjustment submodule is turned on.

On/off states of the two first adjustment submodules affect the output status of the second branch circuit. When one first adjustment submodule in the two first adjustment submodules is turned on and the other first adjustment submodule is turned off, the second radio frequency output port 25 outputs a signal. When the two first adjustment submodules are both turned on or turned off, the second radio frequency output port 25 outputs no signal. That the second radio frequency port 25 outputs no signal means that the second branch circuit outputs no signal. It may be considered that the second branch circuit is open. In other words, the phase-shift filtering network can control closure/openness of the second branch circuit to implement a switch function.

In addition, phases of signals output by the second radio frequency output port are different when different first adjustment submodules are turned on or turned off. To be specific, it is assumed that the two first adjustment submodules included in the filtering phase-shift network are an adjustment submodule A and an adjustment submodule B. When the adjustment submodule A is turned off and the adjustment submodule B is turned on, a phase of a signal output by the second radio frequency output port is P1; and when the adjustment submodule A is turned on and the adjustment submodule B is turned off, a phase of a signal output by the second radio frequency output port is P2. P1 is different from P2. Therefore, a phase-shift function is implemented.

In some optional implementations, the first adjustment submodule in the phase-shift filtering network may alternatively have another structure. For example, as shown in FIG. 3b, each first adjustment submodule includes a first adjustment stub 2421, a first electric control component 2426, and a first control end 2425 that are sequentially connected. The first electric control component 2426 is further grounded.

In an embodiment shown in FIG. 3b, the first control end 2425 is configured to control an on/off state of the first electric control component 2426, to control an on/off state of the first adjustment submodule. To be specific, if the first electric control component 2426 is turned off, it is considered that the first adjustment submodule is turned off; and if the first electric control component 2426 is turned on, it is considered that the first adjustment submodule is turned on. There are a plurality of possibilities for the first electric control component 2426, including an MEMS switch, a monolithic tube, or another component having a switch function. This is not specifically limited herein.

### 1.2. The bridge is a 90° bridge.

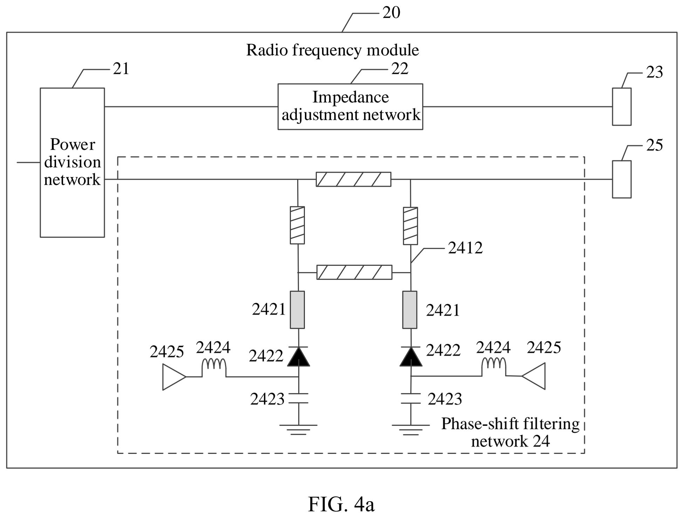

FIG. 4a to FIG. 4c each are a diagram of a structure of a radio frequency module according to an embodiment of this application.

In an embodiment shown in FIG. 4a, a bridge 2412 is a 90° bridge. Components included in each of the two first adjustment submodules and a connection relationship between the components are similar to those in the embodiment shown in FIG. 3a. Details are not described herein.

On/off states of the two first adjustment submodules also affect the output status of the second branch circuit. However, different from the embodiment shown in FIG. 3a, in the embodiment shown in FIG. 4a, when one first adjustment submodule in the two first adjustment submodules is turned on and the other first adjustment submodule is turned off, the second radio frequency output port 25 outputs no signal. When the two first adjustment submodules are both turned on or turned off, the second radio frequency output port 25 outputs a signal.

In addition, a phase of a signal output by the second radio frequency when the two first adjustment submodules are both turned off is different from a phase of a signal output by the second radio frequency when the two first adjustment submodules are both turned on. To be specific, it is assumed that the two first adjustment submodules included in the filtering phase-shift network are an adjustment submodule A and an adjustment submodule B. When the adjustment submodule A and the adjustment submodule B are both turned on, a phase of a signal output by the second radio frequency output port is P1; and when the adjustment submodule A and the adjustment submodule B are both turned off, a phase of a signal output by the second radio frequency output port is P2. P1 is different from P2. Therefore, a phase-shift function is implemented.

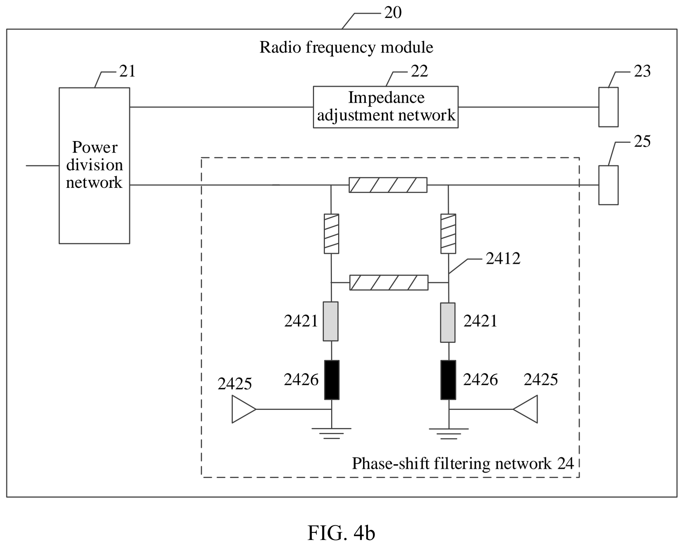

When the bridge in the phase-shift filtering network is a 90° bridge, there are also a plurality of possibilities for components included in the first adjustment submodule and a connection relationship between the components. As shown in FIG. 4b, each first adjustment submodule includes a first adjustment stub 2421, a first electric control component 2426, and a first control end 2425 that are sequentially connected. The first electric control component 2426 is further grounded. Specifically, the components and a connection relationship between the components are similar to those in the embodiment shown in FIG. 3b. Details are not described herein.

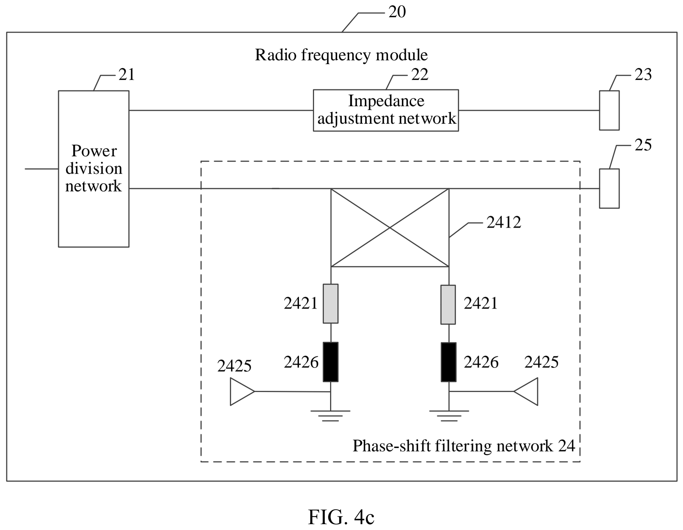

It may be understood that, in actual application, the 90° bridge may alternatively be represented by using a drawing method of a bridge 2412 in an embodiment shown in FIG. 4c. This is not specifically limited herein.

In this application, regardless of whether the bridge in the phase-shift filtering network is a 180° bridge or a 90° bridge, there are a plurality of possibilities for components included in the first adjustment submodule and a connection relationship between the components, so that different requirements can be met. This improves flexibility and practicability of the technical solutions of this application.

In the foregoing descriptions, a structure in which the phase-shift filtering network includes a bridge and two first adjustment submodules is described. The following describes a structure in which the phase-shift filtering network includes a filtering subnetwork and a phase-shift subnetwork.

2. The phase-shift filtering network includes a filtering subnetwork and a phase-shift subnetwork.

In this structure, the power division network is connected to the filtering subnetwork and the phase-shift subnetwork, and the phase-shift subnetwork is connected to the second radio frequency output port. When the filtering subnetwork is turned off, the phase-shift filtering network performs a phase-shift function, and the second radio frequency output port outputs a signal; and when the filtering subnetwork is turned on, the phase-shift filtering network performs a filtering function, and the second radio frequency output port outputs no signal. That the second radio frequency output port outputs no signal may be understood as that the second branch circuit is open, and a switch function is implemented.

In this application, the phase-shift filtering network may alternatively include an independent filtering subnetwork and an independent phase-shift subnetwork, to implement filtering and phase-shift functions through cooperation between the two subnetworks.

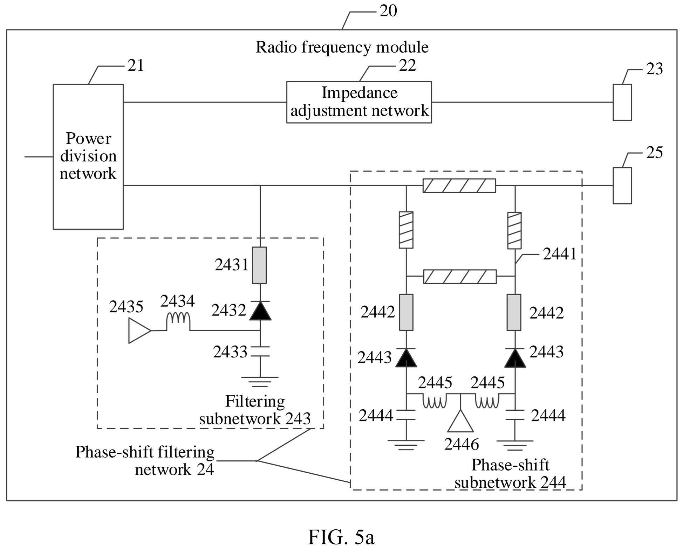

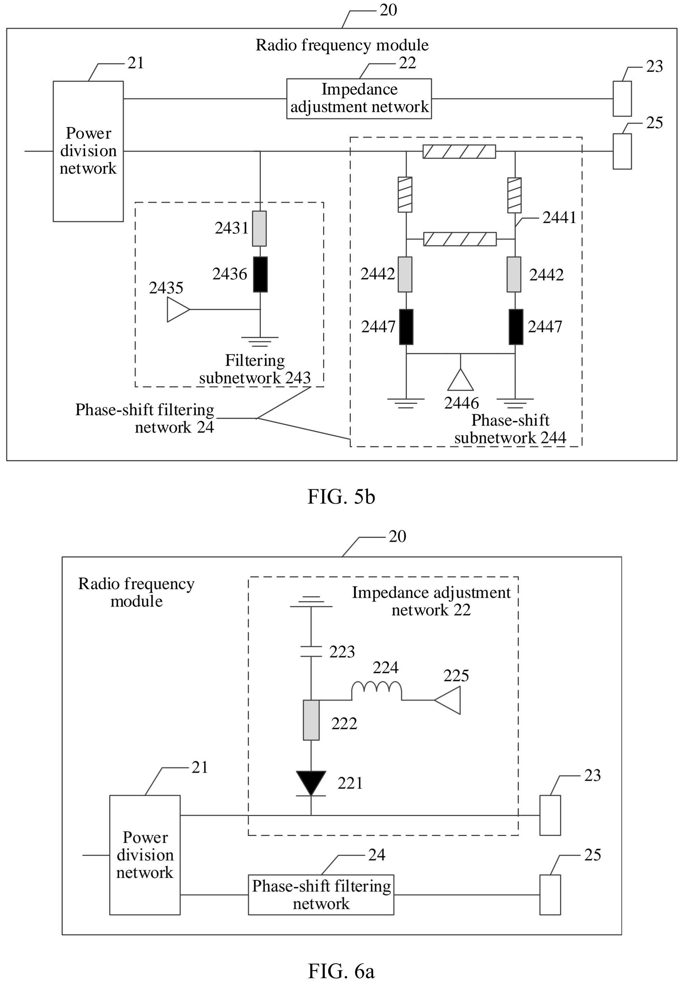

The following provides detailed descriptions with reference to diagrams. FIG. 5a and FIG. 5b each are a diagram of a structure of a radio frequency module according to an embodiment of this application.

As shown in FIG. 5a, a filtering subnetwork 243 includes a third adjustment stub 2431, a third diode 2432, a third capacitor 2433, a third inductor 2434, and a fourth control end 2435. The third adjustment stub 2431 is actually a radio frequency transmission line, and a wavelength of the radio frequency transmission line is determined based on an actual application requirement. This is not specifically limited herein.

The third adjustment stub 2431, the third diode 2432, and the third capacitor 2433 are sequentially connected, the third adjustment stub 2431 is connected to the power division network 21, and the third capacitor 2433 is grounded. The third diode 2432 is further connected to the third inductor 2434, and the third inductor 2434 is further connected to the fourth control end 2435. The fourth control end 2435 is configured to control an on/off state of the third diode 2432.

It should be noted that, the on/off state of the third diode 2432 affects an on/off state of the filtering subnetwork 243. Considering a characteristic of a radio frequency signal, when a wavelength of the third adjustment stub 2431 is an odd multiple of 1/4, the on/off state of the filtering subnetwork 243 is different from the on/off state of the third diode 2432. Specifically, when the third diode 2432 is turned on, it is equivalent that the filtering subnetwork 243 is in an off state, and in this case, the second radio frequency output port 25 outputs a signal; and when the third diode 2432 is cut off, it is equivalent that the filtering subnetwork 243 is in an on state, and in this case, the second radio frequency output port 25 outputs no signal. When a wavelength of the third adjustment stub 2431 is an even multiple of 1/4, the on/off state of the filtering subnetwork 243 is the same as the on/off state of the third diode 2432. Specifically, that the third diode 2432 is turned on means that the filtering subnetwork 243 is in an on state, and in this case, the second radio frequency output port 25 outputs no signal; and that the third diode 2432 is cut off means that the filtering subnetwork 243 is in an off state, and in this case, the second radio frequency output port 25 outputs a signal.

In this embodiment of this application, there are a plurality of possibilities for a structure of the filtering subnetwork 243. For example, as shown in FIG. 5b, a filtering subnetwork 243 includes a third adjustment stub 2431, a third electric control component 2436, and a fourth control end 2435 that are sequentially connected. The third electric control component 2436 is further grounded.

In an embodiment shown in FIG. 5b, the fourth control end 2435 is configured to control an on/off state of the third electric control component 2436, to control an on/off state of the filtering subnetwork 243. To be specific, if the third electric control component 2436 is turned off, it is considered that the filtering subnetwork 243 is turned off; and if the third electric control component 2436 is turned on, it is considered that the filtering subnetwork 243 is turned on. There are a plurality of possibilities for the third electric control component 2436, including an MEMS switch, a monolithic tube, or another component having a switch function. This is not specifically limited herein.

As shown in FIG. 5a, the phase-shift subnetwork 244 includes a 90° bridge 2441, two second adjustment submodules, and a fifth control end 2446. An input end of the 90° bridge 2441 is connected to the filtering subnetwork 243 and the power division network 21, and three output ends of the 90° bridge 2441 are respectively connected to the two second adjustment submodules and the second radio frequency output port 25. The fifth control end 2446 is configured to control on/off states of the two second adjustment submodules.

Each of the two second adjustment submodules includes a fourth adjustment stub 2442, a fourth diode 2443, a fourth capacitor 2444, and a fourth inductor 2445. The fourth adjustment stub 2442, the fourth diode 2443, and the fourth capacitor 2444 are sequentially connected, the fourth adjustment stub 2442 is connected to an output end of the 90° bridge 2441, and the fourth capacitor 2444 is grounded. The fourth diode 2443 is further connected to the fourth inductor 2445, and the fourth inductor 2445 is connected to the fifth control end 2446.

The fifth control end 2446 controls two fourth diodes 2443 to be both turned off or both turned on. When the filtering subnetwork 243 is in an off state, regardless of whether the two fourth diodes 2443 are both turned off or both turned on, the second radio frequency output port 25 outputs a signal. However, a phase of a signal output by the second radio frequency output port 25 when the two fourth diodes 2443 are both turned off is different from a phase of a signal output by the second radio frequency output port 25 when the two fourth diodes 2443 are both turned on. Therefore, a phase-shift function is implemented.

In some optional implementations, the second adjustment submodule in the phase-shift subnetwork 244 may alternatively have another structure. For example, as shown in FIG. 5b, each second adjustment submodule includes a fourth adjustment stub 2442 and a fourth electric control component 244 that are sequentially connected. The fourth electric control component 2447 is further connected to the fifth control end 2446 and grounded.

In the embodiment shown in FIG. 5b, the fifth control end 2446 is configured to control an on/off state of the fourth electric control component 2447, to control an on/off state of the second adjustment submodule. There are a plurality of possibilities for the fourth electric control component 2447, including an MEMS switch, a monolithic tube, or another component having a switch function. This is not specifically limited herein.

It should be noted that, in actual application, in addition to the combination manners shown in FIG. 5a and FIG. 5b, there may be another combination manner for the filtering subnetwork and the phase-shift subnetwork. For example, the filtering subnetwork 243 shown in FIG. 5a and the phase-shift subnetwork 244 shown in FIG. 5b are combined in a same radio frequency module, or the filtering subnetwork 243 shown in FIG. 5b and the phase-shift subnetwork 244 shown in FIG. 5a are combined in a same radio frequency module. This is not specifically limited herein.

The foregoing describes the phase-shift filtering network in embodiments of this application. The following describes the impedance adjustment network in the radio frequency module provided in embodiments of this application.

The impedance adjustment network in embodiments of this application may be connected to a circuit in a form of a short-circuit stub, or may be connected to a circuit in a form of an open-circuit stub. This is not specifically limited herein. The following separately provides descriptions.
1. The impedance adjustment network may be in a form of a short-circuit stub.

In general, for a structure in which the impedance adjustment network is connected to a circuit in a form of a short-circuit stub, impedance of the impedance adjustment network in a case in which the impedance adjustment network is turned on is greater than impedance of the impedance adjustment network in a case in which the impedance adjustment network is turned off. In addition, when the impedance adjustment network is turned on, both the first radio frequency output port 23 and the second radio frequency output port 25 output signals; and when the impedance adjustment network is turned off, only the first radio frequency output port 23 outputs a signal.

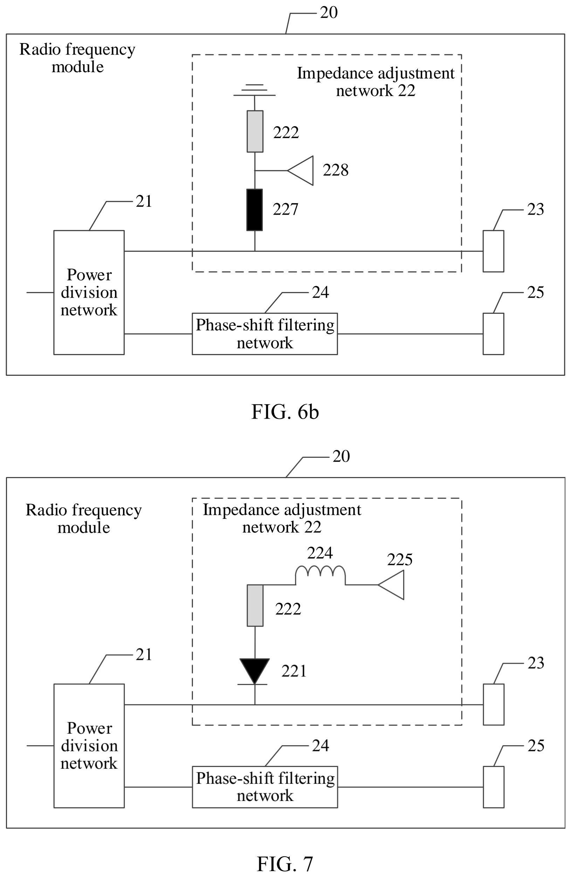

To clearly describe a structure of the impedance adjustment network, refer to FIG. 6a and FIG. 6b. FIG. 6a and FIG. 6b each are a diagram of a structure of a radio frequency module according to an embodiment of this application.

In some optional implementations, as shown in FIG. 6a, the impedance adjustment network 22 includes a second diode 221, a second adjustment stub 222, a second capacitor 223, a second inductor 224, and a second control end 225.

The second diode 221, the second adjustment stub 222, and the second capacitor 223 are sequentially connected, the second diode 221 is further connected to the power division network 21 and the first radio frequency output port 23, and the second capacitor 223 is further grounded. The second adjustment stub 222 is connected to the second inductor 224, and the second inductor 224 is connected to the second control end 225. The second adjustment stub 222 is actually a radio frequency transmission line, and a wavelength of the radio frequency transmission line may be determined based on an actual application requirement. This is not specifically limited herein.

The second control end 225 is configured to control on/off of the second diode 221. Impedance of the impedance adjustment network 22 in a case in which the second diode 221 is turned on is greater than impedance of the impedance adjustment network 22 in a case in which the second diode 221 is turned off. Specifically, a voltage of the second control end 225 may be adjusted to control on/off of the second diode 221.

In some optional implementations, as shown in FIG. 6b, the impedance adjustment network 22 may alternatively include a second electric control component 227, a third control end 228, and a second adjustment stub 222.

The second electric control component 227 is connected to the power division network 21, the first radio frequency output port 23, the third control end 228, and the second adjustment stub 222, and the second adjustment stub 222 is grounded.

The third control end 228 is configured to control on/off of the second electric control component 227. Impedance of the impedance adjustment network 22 in a case in which the second electric control component 227 is turned on is greater than impedance of the impedance adjustment network in a case in which the second electric control component 227 is turned off. The second electric control component 227 includes an MEMS switch, a monolithic tube, or another component having a switch function. This is not specifically limited herein.

2. The impedance adjustment network may be in a form of an open-circuit stub.

For a structure in which the impedance adjustment network is connected to a circuit in a form of an open-circuit stub, impedance of the impedance adjustment network in a case in which the impedance adjustment network is turned on is less than impedance of the impedance adjustment network in a case in which the impedance adjustment network is turned off.

FIG. 7 is a diagram of a structure of a radio frequency module according to an embodiment of this application.

As shown in FIG. 7, the impedance adjustment network 22 includes a second diode 221, a second adjustment stub 222, a second inductor 224, and a second control end 225.

The second diode 221, the second adjustment stub 222, the second inductor 224, and the second control end 225 are sequentially connected, and the second diode 221 is further connected to the power division network 21 and the first radio frequency output port 23. The second adjustment stub 222 is actually a radio frequency transmission line, and a wavelength of the radio frequency transmission line may be determined based on an actual application requirement. This is not specifically limited herein.

The second control end 225 is configured to control on/off of the second diode 221. Impedance of the impedance adjustment network 22 in a case in which the second diode 221 is turned on is less than impedance of the impedance adjustment network 22 in a case in which the second diode 221 is turned off. Specifically, a voltage of the second control end 225 may be adjusted to control on/off of the second diode 221.

In this application, there are a plurality of possibilities for components included in the impedance adjustment network and a connection relationship between the components, so that different requirements can be met. This improves flexibility and practicability of the technical solutions of this application.

The foregoing separately describes the filtering phase-shift network and the impedance adjustment network in the radio frequency module that is in the branch circuit matching mode and that is provided in embodiments of this application. It should be noted that, in actual application, any one of the foregoing filtering phase-shift networks and any one of the foregoing impedance adjustment networks may be included in a same radio frequency module. When the radio frequency module includes a plurality of second branch circuits, filtering phase-shift networks of all the second branch circuits may use a same structure, or may use different structures. This is not specifically limited herein.

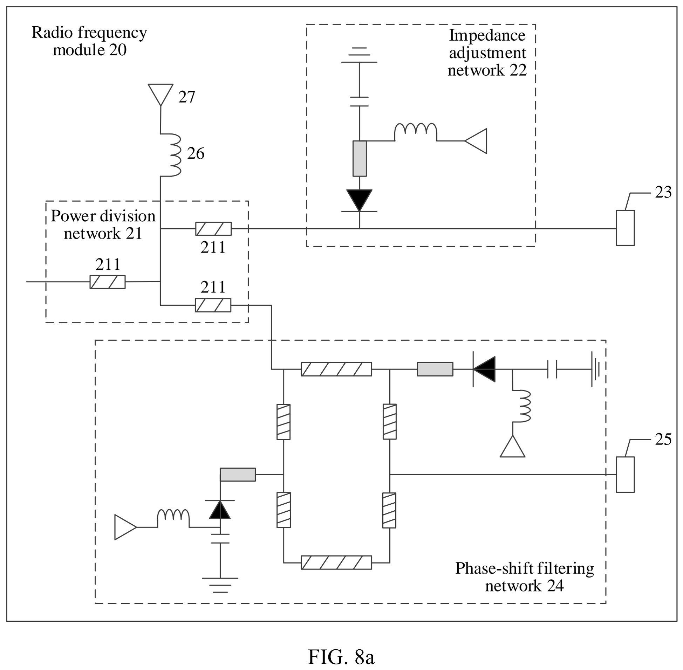

For example, the following describes some radio frequency modules in the branch circuit matching mode with reference to diagrams. FIG. 8a to FIG. 10 each are a diagram of a structure of a radio frequency module according to an embodiment of this application.

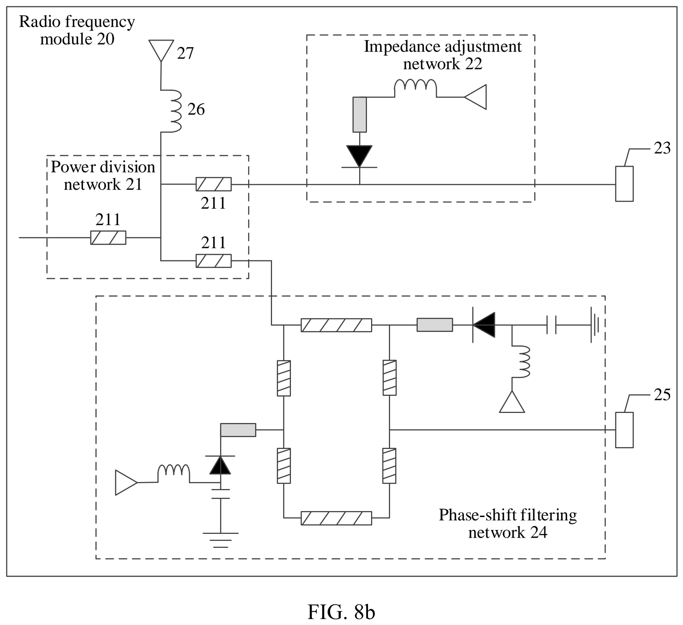

As shown in FIG. 8a and FIG. 8b, a radio frequency signal is divided into two signals through a power division network 21, respectively entering a first branch circuit and a second branch circuit. The first branch circuit includes an impedance adjustment network 22 and a first radio frequency output port 23, and the second branch circuit includes a filtering phase-shift network 24 and a second radio frequency output port 25.

An example in which the phase-shift filtering network 24 includes a 180° bridge and two first adjustment submodules is used in both embodiments shown in FIG. 8a and FIG. 8b. A structure of the phase-shift filtering network 24 is similar to that of the phase-shift filtering network 24 shown in FIG. 3a. Details are not described herein. A difference lies in that, in an embodiment shown in FIG. 8a, the impedance adjustment network 22 is a short-circuit stub, and a specific structure of the impedance adjustment network 22 is similar to that of the impedance adjustment network 22 shown in FIG. 6a; and in an embodiment shown in FIG. 8b, the impedance adjustment network 22 is an open-circuit stub, and a specific structure of the impedance adjustment network 22 is similar to that of the impedance adjustment network 22 shown in FIG. 7. Details are not described herein.

In general, in the embodiments shown in FIG. 8a and FIG. 8b, when the two first adjustment submodules in the phase-shift filtering network 24 are in different on/off states, radio frequency signals are output through the first radio frequency output port 23 and the second radio frequency output port 25; and when the two first adjustment submodules in the phase-shift filtering network 24 are in a same on/off state, only the first radio frequency output port 23 outputs a radio frequency signal.

In some optional implementations, for ease of control, the radio frequency module 20 in the branch circuit matching mode further includes a choke inductor 26 and a common control end 27. A combination of the choke inductor 26 and the common control end 27 may be placed at any position of a circuit, provided that cathodes of all diodes in the circuit are connected to the common control end 27, and anodes are independently controlled; or anodes of all diodes in the circuit are connected to the common control end 27, and cathodes are independently controlled. This is not specifically limited herein.

In some optional implementations, the choke inductor 26 and the common control end 27 may not be disposed, but a control end is separately configured for each diode, so that the diode can normally work. In addition, normal working of the diode may be ensured in another manner. For example, one end of each diode is grounded, and an electric potential difference is formed between two ends of the diode. This is not specifically limited herein.

In some optional implementations, the power division network 21 may further include a plurality of radio frequency transmission lines 211, configured to: when the diode is turned off, ensure that the circuit is in a pre-matching state; and when the diode is turned on, act together with the impedance adjustment network to adjust impedance of the circuit, to increase or reduce the impedance. For example, in the embodiment shown in FIG. 8a, the power division network 21 includes three radio frequency transmission lines. In actual application, the power division network 21 may alternatively include more or fewer radio frequency transmission lines. Both a wavelength and a position of the radio frequency transmission line may be determined based on an actual application requirement. This is not specifically limited herein.

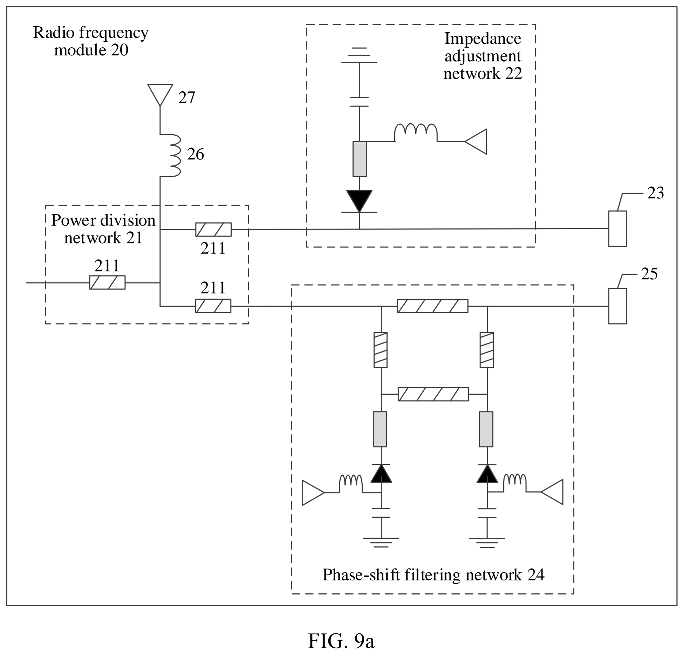

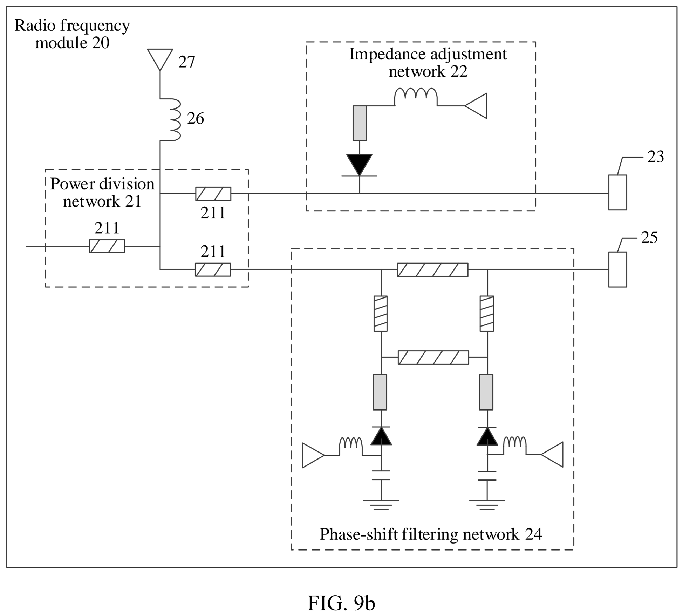

An example in which the phase-shift filtering network 24 includes a 90° bridge and two first adjustment submodules is used in both embodiments shown in FIG. 9a and FIG. 9b. A structure of the phase-shift filtering network 24 is similar to that of the phase-shift filtering network 24 shown in FIG. 4a. Details are not described herein. A difference lies in that, in an embodiment shown in FIG. 9a, the impedance adjustment network 22 is a short-circuit stub, and a specific structure of the impedance adjustment network 22 is similar to that of the impedance adjustment network 22 shown in FIG. 6a; and in an embodiment shown in FIG. 9b, the impedance adjustment network 22 is an open-circuit stub, and a specific structure of the impedance adjustment network 22 is similar to that of the impedance adjustment network 22 shown in FIG. 7. Details are not described herein.

In general, in the embodiments shown in FIG. 9a and FIG. 9b, when the two first adjustment submodules in the phase-shift filtering network 24 are in different on/off states, only the first radio frequency output port 23 outputs a radio frequency signal; and when the two first adjustment submodules in the phase-shift filtering network 24 are in a same on/off state, radio frequency signals are output through the first radio frequency output port 23 and the second radio frequency output port 25.

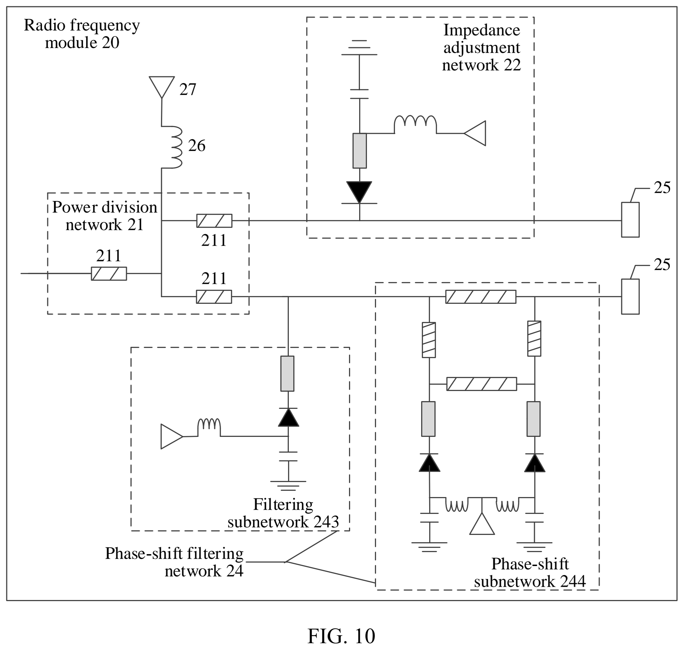

An example in which the phase-shift filtering network 24 includes a filtering subnetwork 243 and a phase-shift subnetwork 244 and the impedance adjustment network 22 is a short-circuit stub is used in an embodiment shown in FIG. 10. A structure of the phase-shift filtering network 24 is similar to that of the phase-shift filtering network 24 shown in FIG. 5a, and a specific structure of the impedance adjustment network 22 is similar to that of the impedance adjustment network 22 shown in FIG. 6a. Details are not described herein.

II. Radio frequency module in a main circuit matching mode.

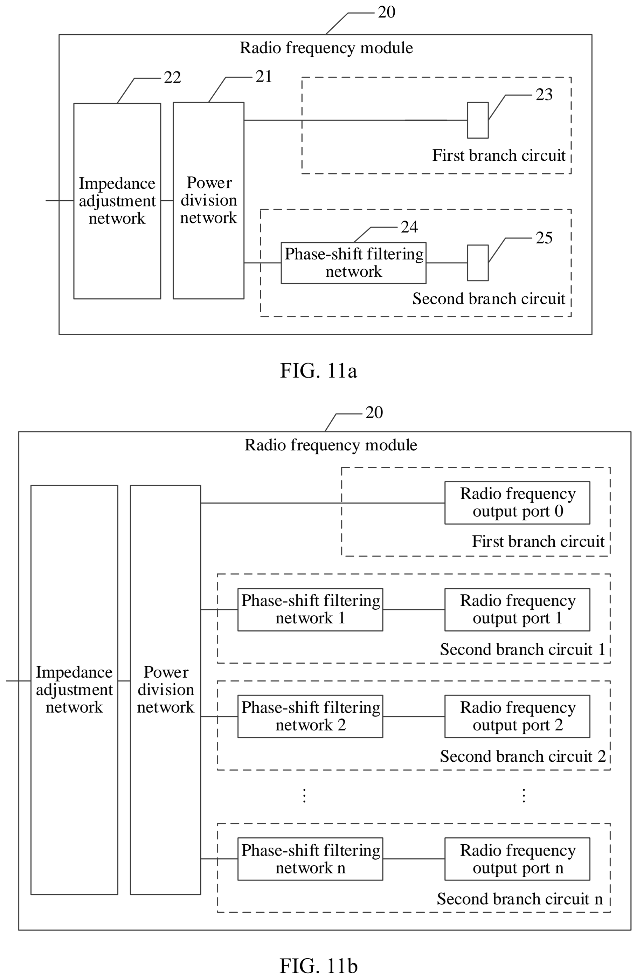

The foregoing describes the radio frequency module in the branch circuit matching mode. The following describes the radio frequency module in the main circuit matching mode. FIG. 11a and FIG. 11b each are a diagram of a structure of a radio frequency module according to an embodiment of this application.

As shown in FIG. 11a, a radio frequency module 20 includes an impedance adjustment network 22, a power division network 21, a first branch circuit, and a second branch circuit. The first branch circuit includes a first radio frequency output port 23, and the second branch circuit includes a phase-shift filtering network 24 and a second radio frequency output port 25.

A radio frequency input end is connected to the impedance adjustment network 22 and the power division network 21, the power division network 21 is further connected to the first radio frequency output port 23 and the phase-shift filtering network 24, and the phase-shift filtering network 24 is connected to the second radio frequency output port 25. In other words, the impedance adjustment network 22 and the power division network 21 are located on a main circuit of the radio frequency module 20, and the phase-shift filtering network 24 is located on a branch circuit of the radio frequency module 20.

A radio frequency signal from the outside of the radio frequency module 20 may enter the radio frequency module 20 through the radio frequency input end, and the radio frequency input end is connected to the impedance adjustment network 22. The radio frequency input end includes a radio frequency input port and a radio frequency transmission line. A line at a leftmost end in FIG. 11a represents the radio frequency transmission line, and the radio frequency input port is not shown in FIG. 11a. In some optional implementations, the radio frequency module 20 may include the radio frequency input port, and the radio frequency input port is connected to the radio frequency transmission line at the leftmost end in FIG. 11a. To be specific, the radio frequency signal enters the impedance adjustment network 22 through the radio frequency input end, and is divided into two signals after being processed by the power division network 21, and the two signals respectively enter the first branch circuit and the second branch circuit. It should be noted that, an example in which the radio frequency module 20 does not include the radio frequency input port is used in all the following descriptions.

The impedance adjustment network 22 and the power division network 21 are jointly configured to adjust first power of the first branch circuit and second power of the second branch circuit. The phase-shift filtering network 24 is configured to control an output status of the second branch circuit and a phase of an output signal of the second branch circuit. The output status of the second branch circuit indicates whether the second branch circuit outputs a signal, in other words, whether the second radio frequency output port 25 outputs a signal.

It should be noted that, FIG. 11a shows an example in which the radio frequency module 20 includes one first branch circuit and one second branch circuit. In actual application, the radio frequency module 20 may alternatively include more second branch circuits. This is not specifically limited herein.

For example, as shown in FIG. 11b, a radio frequency module 20 includes one first branch circuit and n second branch circuits, where n≥3. The first branch circuit includes a radio frequency output port 0, and each second branch circuit includes one phase-shift filtering network and one radio frequency output port. For a structure in which the radio frequency module 20 includes a plurality of second branch circuits, the impedance adjustment network and the power division network are jointly configured to determine power of the first branch circuit and power of each second branch circuit. Each phase-shift filtering network is configured to control an output status of a second branch circuit on which the phase-shift filtering network is located and a phase of an output signal of the second branch circuit.

In this embodiment of this application, the power division network is configured to allocate power of each branch circuit, and the impedance adjustment network adjusts impedance of the first branch circuit based on the power that is of the first branch circuit and that is allocated by the power division network, to jointly implement a power division function. The phase-shift filtering network can control the output status of the second branch circuit to implement a switch function, and can also adjust the phase of the output signal of the second branch circuit to implement a phase-shift function. In other words, the radio frequency module provided in this application implements integration of switch, phase-shift, and power division functions, and the radio frequency module has diversified functions.

In this embodiment of this application, the impedance adjustment network and the phase-shift filtering network cooperate with each other in terms of working modes. Specifically, when the second radio frequency output port outputs no signal, the impedance adjustment network adjusts the impedance of the first branch circuit to first impedance; and when the second radio frequency output port outputs a signal, adjusts the impedance of the first branch circuit to second impedance. The second impedance is greater than the first impedance. To be specific, the first impedance of the first branch circuit in a case in which the phase-shift filtering network is in a filtering state (a state in which the phase-shift filtering network controls the second radio frequency output port to output no signal) is less than the second impedance of the first branch circuit in a case in which the phase-shift filtering network is in a phase-shift state (a state in which the phase-shift filtering network controls the second radio frequency output port to output a signal). In addition, it should be further noted that, when the phase-shift filtering network is in the filtering state, that the second radio frequency output port outputs no signal may also be understood as that a signal output channel of the second branch circuit is closed, and a switch function is implemented.

In this application, the impedance adjustment network and the phase-shift filtering network cooperate with each other, so that impedance of the branch circuit matches impedance of the main circuit. This ensures that the radio frequency module can normally work, and improves implementability and practicability of the technical solutions of this application.

For brevity of description, an example in which the radio frequency module includes one first branch circuit and one second branch circuit is used in all the following descriptions of the radio frequency module of the branch circuit matching mode type.

Similar to the radio frequency module in the branch circuit matching mode, there are also a plurality of possibilities for a structure of the phase-shift filtering network in the radio frequency module in the main circuit matching mode. The phase-shift filtering network may include a bridge and two first adjustment submodules, or may include a filtering subnetwork and a phase-shift subnetwork. This is not specifically limited herein. The following separately provides descriptions.

In some optional implementations, the phase-shift filtering network includes a bridge and two first adjustment submodules. An input end of the bridge is connected to the power division network, and three output ends of the bridge are respectively connected to the two first adjustment submodules and the second radio frequency output port. The two first adjustment submodules are configured to control whether the second radio frequency output port outputs a signal and a phase of an output signal of the second radio frequency output port. If the bridge is a 180° bridge, when the two first adjustment submodules are in a same on/off state, the second radio frequency output port outputs no signal; and when the two first adjustment submodules are in different on/off states, the second radio frequency output port outputs a signal. If the bridge is a 90° bridge, when the two first adjustment submodules are in different on/off states, the second radio frequency output port outputs no signal; and when the two first adjustment submodules are in a same on/off state, the second radio frequency output port outputs a signal.

In this application, the bridge included in the phase-shift filtering network has a plurality of forms. This enriches implementations of the technical solutions of this application. In addition, in different bridge forms, the two first adjustment submodules configured to determine whether the second radio frequency module outputs a signal are in different on/off states. This is adapted to a change of the bridge.

In addition, the first adjustment submodule in the phase-shift filtering network has a plurality of structures.

Optionally, each of the two first adjustment submodules includes a first adjustment stub, a first diode, a first capacitor, a first inductor, and a first control end. In this case, a specific structure and function of the first adjustment submodule are similar to those in the embodiment shown in FIG. 3a or FIG. 4a. Details are not described herein.

Optionally, each of the two first adjustment submodules includes a first adjustment stub, a first electric control component, and a first control end that are sequentially connected. In this case, a specific structure and function of the first adjustment submodule are similar to those in the embodiment shown in FIG. 3b, FIG. 4b, or FIG. 4c. Details are not described herein.

In this application, there are a plurality of possibilities for components included in the first adjustment submodule and a connection relationship between the components, so that different requirements can be met. This improves flexibility and practicability of the technical solutions of this application.

In some optional implementations, the phase-shift filtering network includes a filtering subnetwork and a phase-shift subnetwork. The power division network is connected to the filtering subnetwork and the phase-shift subnetwork, and the phase-shift subnetwork is connected to the second radio frequency output port. When the filtering subnetwork is turned off, the phase-shift filtering network performs a phase-shift function, and the second radio frequency output port outputs a signal; and when the filtering subnetwork is turned on, the phase-shift filtering network performs a filtering function, and the second radio frequency output port outputs no signal.

In this application, the phase-shift filtering network may alternatively include an independent filtering subnetwork and an independent phase-shift subnetwork, to implement filtering and phase-shift functions through cooperation between the two subnetworks.

Optionally, the filtering subnetwork includes a third adjustment stub, a third diode, a third capacitor, a third inductor, and a fourth control end. In this case, a specific structure of the filtering subnetwork is similar to that of the filtering subnetwork 243 shown in FIG. 5a. Details are not described herein.

Optionally, the filtering subnetwork includes a third adjustment stub, a third electric control component, and a fourth control end that are sequentially connected. In this case, a specific structure of the filtering subnetwork is similar to that of the filtering subnetwork 243 shown in FIG. 5b. Details are not described herein.

The phase-shift subnetwork includes a 90° bridge, two second adjustment submodules, and a fifth control end. An input end of the 90° bridge is connected to the filtering subnetwork and the power division network, and three output ends of the 90° bridge are respectively connected to the two second adjustment submodules and the second radio frequency output port. The fifth control end is configured to control on/off states of the two second adjustment submodules.

Optionally, each of the two second adjustment submodules includes a fourth adjustment stub, a fourth diode, a fourth capacitor, and a fourth inductor. The fourth adjustment stub, the fourth diode, and the fourth capacitor are sequentially connected, the fourth adjustment stub is connected to an output end of the 90° bridge, and the fourth capacitor is grounded. The fourth diode is further connected to the fourth inductor, and the fourth inductor is connected to the fifth control end. A specific structure of the phase-shift subnetwork is similar to that of the phase-shift subnetwork 244 shown in FIG. 5a. Details are not described herein.

Optionally, the second adjustment submodule in the phase-shift subnetwork may alternatively have another structure. For example, each second adjustment submodule includes a fourth adjustment stub and a fourth electric control component that are sequentially connected. A specific structure of the phase-shift subnetwork is similar to that of the phase-shift subnetwork 244 shown in FIG. 5b. Details are not described herein.

Similar to the radio frequency module in the branch circuit matching mode, there are also a plurality of possibilities for a structure of the impedance adjustment network in the radio frequency module in the main circuit matching mode. The impedance adjustment network may be a short-circuit stub, or may be an open-circuit stub. This is not specifically limited herein. The following separately provides descriptions.

In some optional implementations, the impedance adjustment network is a short-circuit stub, and there are a plurality of possibilities for a structure of the impedance adjustment network.

Optionally, the impedance adjustment network includes a second diode, a second adjustment stub, a second capacitor, a second inductor, and a second control end. The second diode, the second adjustment stub, and the second capacitor are sequentially connected, the second diode is connected to the power division network and the first radio frequency output port, and the second capacitor is grounded. The second adjustment stub is connected to the second inductor, and the second inductor is connected to the second control end. The second control end is configured to control on/off of the second diode. Impedance of the impedance adjustment network in a case in which the second diode is turned on is greater than impedance of the impedance adjustment network in a case in which the second diode is turned off. In this case, a specific structure of the impedance adjustment network is similar to that of the impedance adjustment network 22 shown in FIG. 6a. Details are not described herein.

Optionally, the impedance adjustment network includes a second electric control component, a third control end, and a second adjustment stub. The second electric control component is connected to the power division network, the first radio frequency output port, the third control end, and the second adjustment stub, and the second adjustment stub is grounded. The third control end is configured to control on/off of the second electric control component. Impedance of the impedance adjustment network in a case in which the second electric control component is turned on is greater than impedance of the impedance adjustment network in a case in which the second electric control component is turned off. The second electric control component includes an MEMS switch, a monolithic tube, or another component having a switch function. This is not specifically limited herein. In this case, a specific structure of the impedance adjustment network is similar to that of the impedance adjustment network 22 shown in FIG. 6b. Details are not described herein.

In some optional implementations, the impedance adjustment network may be connected to a circuit in a form of an open-circuit stub, and the impedance adjustment network includes a second diode, a second adjustment stub, a second inductor, and a second control end. In this case, a specific structure of the impedance adjustment network is similar to that of the impedance adjustment network 22 shown in FIG. 7. Details are not described herein.

In this application, there are a plurality of possibilities for components included in the impedance adjustment network and a connection relationship between the components, so that different requirements can be met. This improves flexibility and practicability of the technical solutions of this application.

The foregoing separately describes the filtering phase-shift network and the impedance adjustment network in the radio frequency module that is in the main circuit matching mode and that is provided in embodiments of this application. It should be noted that, in actual application, any one of the foregoing filtering phase-shift networks and any one of the foregoing impedance adjustment networks may be included in a same radio frequency module. For a structure in which the radio frequency module includes a plurality of second branch circuits, filtering phase-shift networks of all the second branch circuits may use a same structure, or may use different structures. This is not specifically limited herein.

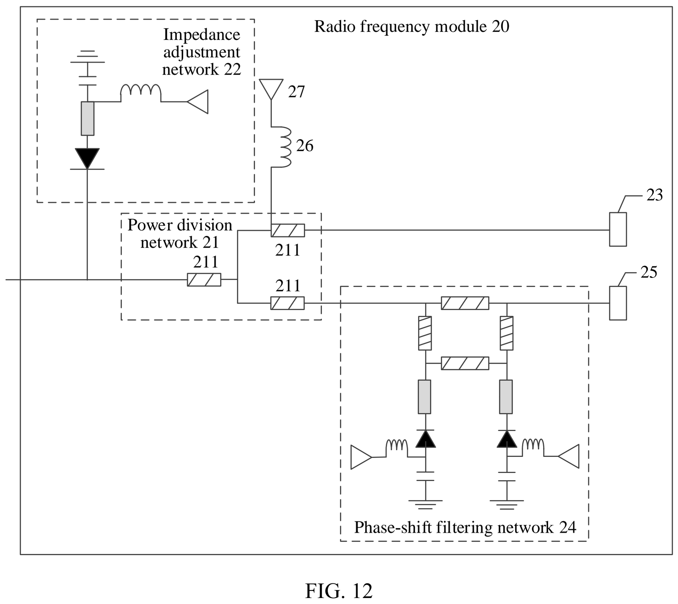

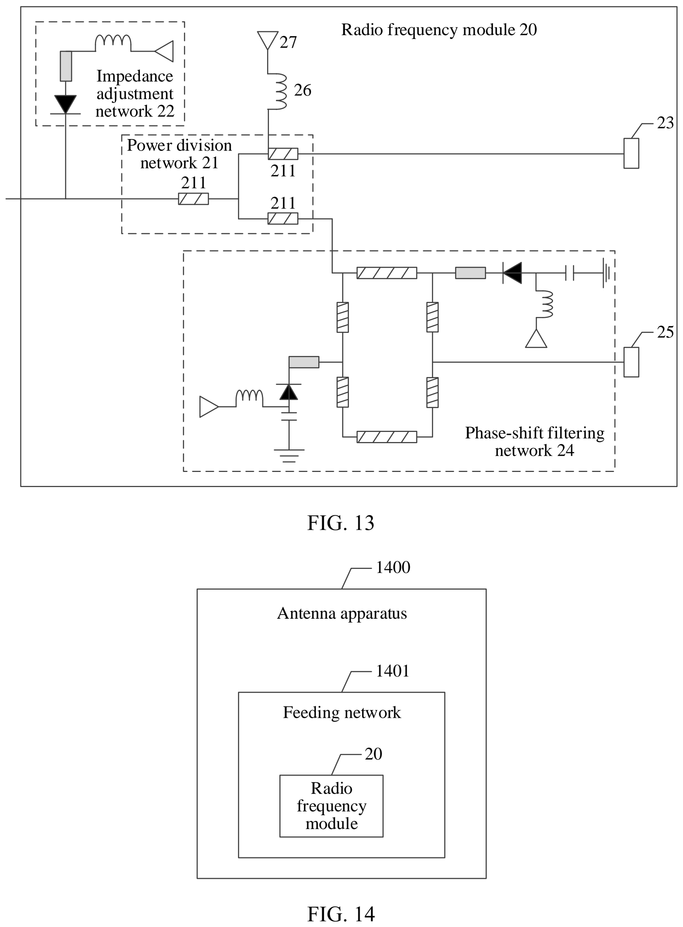

For example, the following describes some radio frequency modules in the main circuit matching mode with reference to diagrams. FIG. 12 and FIG. 13 each are a diagram of a structure of a radio frequency module according to an embodiment of this application.

In an embodiment shown in FIG. 12, a radio frequency input port is connected to a power division network 21 through an impedance adjustment network 22, and the power division network 21 divides a radio frequency signal into two signals. A first branch circuit includes a first radio frequency output port 23, and a second branch circuit includes a filtering phase-shift network 24 and a second radio frequency output port 25.

An example in which the impedance adjustment network 22 is an open-circuit stub and the phase-shift filtering network 24 includes a 90° bridge and two first adjustment submodules is used in the embodiment shown in FIG. 12. A structure of the impedance adjustment network 22 is similar to that of the impedance adjustment network 22 shown in FIG. 7, and a structure of the phase-shift filtering network 24 is similar to that of the phase-shift filtering network 24 shown in FIG. 4a. Details are not described herein.

In general, in the embodiment shown in FIG. 12, when the two first adjustment submodules in the phase-shift filtering network 24 are in different on/off states, only the first radio frequency output port 23 outputs a radio frequency signal; and when the two first adjustment submodules in the phase-shift filtering network 24 are in a same on/off state, radio frequency signals are output through the first radio frequency output port 23 and the second radio frequency output port 25.

An example in which the impedance adjustment network 22 is an open-circuit stub and the phase-shift filtering network 24 includes a 180° bridge and two first adjustment submodules is used in an embodiment shown in FIG. 13. A structure of the impedance adjustment network 22 is similar to that of the impedance adjustment network 22 shown in FIG. 7, and a structure of the phase-shift filtering network 24 is similar to that of the phase-shift filtering network 24 shown in FIG. 3a. Details are not described herein.

In general, in the embodiment shown in FIG. 13, when the two first adjustment submodules in the phase-shift filtering network 24 are in different on/off states, radio frequency signals are output through the first radio frequency output port 23 and the second radio frequency output port 25; and when the two first adjustment submodules in the phase-shift filtering network 24 are in a same on/off state, only the first radio frequency output port 23 outputs a radio frequency signal.

In some optional implementations, for ease of control, the radio frequency module 20 in the main circuit matching mode further includes a choke inductor 26 and a common control end 27. A combination of the choke inductor 26 and the common control end 27 may be placed at any position of a circuit, provided that cathodes of all diodes in the circuit are connected to the common control end 27, and anodes are independently controlled; or anodes of all diodes in the circuit are connected to the common control end 27, and cathodes are independently controlled. This is not specifically limited herein.

In some optional implementations, the choke inductor 26 and the common control end 27 may not be disposed, but a control end is separately configured for each diode, so that the diode can normally work. In addition, normal working of the diode may be ensured in another manner. For example, one end of each diode is grounded, and an electric potential difference is formed between two ends of the diode. This is not specifically limited herein.

In some optional implementations, the power division network 21 may further include a plurality of radio frequency transmission lines 211, configured to: when the diode is turned off, ensure that the circuit is in a pre-matching state; and when the diode is turned on, act together with the impedance adjustment network to adjust impedance of the circuit, to increase or reduce the impedance. For example, in the embodiment shown in FIG. 8a, the power division network 21 includes three radio frequency transmission lines. In actual application, the power division network 21 may alternatively include more or fewer radio frequency transmission lines. Both a wavelength and a position of the radio frequency transmission line may be determined based on an actual application requirement. This is not specifically limited herein.

Embodiments of this application further provide an antenna apparatus and a communication device. FIG. 14 is a diagram of a structure of an antenna apparatus according to an embodiment of this application.

As shown in FIG. 14, an antenna apparatus 1400 includes a feeding network 1401. The feeding network 1401 includes a radio frequency module 20. The radio frequency module 20 includes any one of the radio frequency modules described above, and can implement a corresponding function.

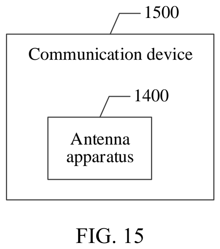

FIG. 15 is a diagram of a structure of a communication device according to an embodiment of this application.

As shown in FIG. 15, a communication device 1500 includes the foregoing antenna apparatus 1400. The communication device may be a base station, a terminal device, or a remote radio unit (remote radio unit, RRU). This is not specifically limited herein.

It may be clearly understood by a person skilled in the art that, for the purpose of convenient and brief description, in the several embodiments provided in this application, it should be understood that the disclosed modules, submodules, networks, subnetworks, and apparatuses may be implemented in other manners.

## Claims

1. A radio frequency module, comprising a power division network, a first branch circuit, and a second branch circuit, wherein the first branch circuit comprises an impedance adjustment network and a first radio frequency output port, and the second branch circuit comprises a phase-shift filtering network and a second radio frequency output port;
the power division network is connected to the first branch circuit and the second branch circuit;
the impedance adjustment network is configured to adjust impedance of the first branch circuit based on power of the first branch circuit; and
the phase-shift filtering network is configured to control an output status of the second branch circuit and a phase of an output signal of the second branch circuit, wherein the output status indicates whether the second branch circuit outputs a signal.

2. The radio frequency module according to claim 1, wherein the impedance adjustment network is specifically configured to:
if the second radio frequency output port outputs no signal, adjust the impedance of the first branch circuit to first impedance; and
if the second radio frequency output port outputs a signal, adjust the impedance of the first branch circuit to second impedance, wherein the second impedance is greater than the first impedance.

3. The radio frequency module according to claim 1 or 2, wherein the phase-shift filtering network comprises a bridge and two first adjustment submodules;
an input end of the bridge is connected to the power division network, and three output ends of the bridge are respectively connected to the two first adjustment submodules and the second radio frequency output port; and
the two first adjustment submodules are configured to control whether the second radio frequency output port outputs a signal and a phase of an output signal of the second radio frequency output port.

4. The radio frequency module according to claim 3, wherein if the bridge is a 180° bridge, when the two first adjustment submodules are in a same on/off state, the second radio frequency output port outputs no signal; and when the two first adjustment submodules are in different on/off states, the second radio frequency output port outputs a signal; or
if the bridge is a 90° bridge, when the two first adjustment submodules are in different on/off states, the second radio frequency output port outputs no signal; and when the two first adjustment submodules are in a same on/off state, the second radio frequency output port outputs a signal.

5. The radio frequency module according to claim 3 or 4, wherein each of the two first adjustment submodules comprises a first adjustment stub, a first diode, a first capacitor, a first inductor, and a first control end;
the first adjustment stub, the first diode, and the first capacitor are sequentially connected, the first adjustment stub is connected to an output end of the bridge, and the first capacitor is grounded;
the first diode is connected to the first inductor, and the first inductor is connected to the first control end; and
the first control end is configured to control an on/off state of the first diode.

6. The radio frequency module according to claim 3 or 4, wherein each of the two first adjustment submodules comprises a first adjustment stub, a first electric control component, and a first control end that are sequentially connected; and
the first electric control component is grounded, and the first control end is configured to control an on/off state of the first electric control component.

7. The radio frequency module according to any one of claims 1 to 6, wherein the impedance adjustment network comprises a second diode, a second adjustment stub, a second capacitor, a second inductor, and a second control end;
the second diode, the second adjustment stub, and the second capacitor are sequentially connected, the second diode is connected to the power division network and the first radio frequency output port, and the second capacitor is grounded;
the second adjustment stub is connected to the second inductor, and the second inductor is connected to the second control end; and
the second control end is configured to control on/off of the second diode, wherein impedance of the impedance adjustment network in a case in which the second diode is turned on is greater than impedance of the impedance adjustment network in a case in which the second diode is turned off.

8. The radio frequency module according to any one of claims 1 to 6, wherein the impedance adjustment network comprises a second electric control component, a third control end, and a second adjustment stub;
the second electric control component is connected to the power division network, the first radio frequency output port, the third control end, and the second adjustment stub, and the second adjustment stub is grounded; and
the third control end is configured to control on/off of the second electric control component, wherein impedance of the impedance adjustment network in a case in which the second electric control component is turned on is greater than impedance of the impedance adjustment network in a case in which the second electric control component is turned off.

9. The radio frequency module according to any one of claims 1, 2, 7, and 8, wherein the phase-shift filtering network comprises a filtering subnetwork and a phase-shift subnetwork;
the power division network is connected to the filtering subnetwork and the phase-shift subnetwork, and the phase-shift subnetwork is connected to the second radio frequency output port; and
when the filtering subnetwork is turned off, the second radio frequency output port outputs a signal; and when the filtering subnetwork is turned on, the second radio frequency output port outputs no signal.

10. The radio frequency module according to claim 9, wherein the filtering subnetwork comprises a third adjustment stub, a third diode, a third capacitor, a third inductor, and a fourth control end;
the third adjustment stub, the third diode, and the third capacitor are sequentially connected, the third adjustment stub is connected to the power division network, and the third capacitor is grounded;
the third diode is connected to the third inductor, and the third inductor is connected to the fourth control end; and
the fourth control end is configured to control an on/off state of the third diode.

11. The radio frequency module according to claim 9, wherein the phase-shift subnetwork comprises a 90° bridge, two second adjustment submodules, and a fifth control end;
an input end of the 90° bridge is connected to the filtering subnetwork and the power division network, and three output ends of the 90° bridge are respectively connected to the two second adjustment submodules and the second radio frequency output port; and
the fifth control end is configured to control on/off states of the two second adjustment submodules.

12. A radio frequency module, comprising an impedance adjustment network, a power division network, a first branch circuit, and a second branch circuit, wherein
the first branch circuit comprises a first radio frequency output port, and the second branch circuit comprises a phase-shift filtering network and a second radio frequency output port;
a radio frequency input end is connected to the impedance adjustment network and the power division network, the power division network is connected to the first radio frequency output port and the phase-shift filtering network, and the phase-shift filtering network is connected to the second radio frequency output port;
the impedance adjustment network and the power division network are configured to adjust first power of the first branch circuit and second power of the second branch circuit; and
the phase-shift filtering network is configured to control an output status of the second branch circuit and a phase of an output signal of the second branch circuit, wherein the output status indicates whether the second branch circuit outputs a signal.

13. The radio frequency module according to claim 12, wherein the impedance adjustment network is specifically configured to:
if the second radio frequency output port outputs no signal, adjust impedance of the impedance adjustment network to first impedance; and
if the second radio frequency output port outputs a signal, adjust impedance of the impedance adjustment network to second impedance, wherein the second impedance is greater than the first impedance.

14. The radio frequency module according to claim 12 or 13, wherein the phase-shift filtering network comprises a bridge and two first adjustment submodules;
an input end of the bridge is connected to the power division network, and three output ends of the bridge are respectively connected to the two first adjustment submodules and the second radio frequency output port; and
the two first adjustment submodules are configured to control whether the second radio frequency output port outputs a signal and a phase of an output signal of the second radio frequency output port.

15. The radio frequency module according to claim 14, wherein if the bridge is a 180° bridge, when the two first adjustment submodules are in a same on/off state, the second radio frequency output port outputs no signal; and when the two first adjustment submodules are in different on/off states, the second radio frequency output port outputs a signal; or
if the bridge is a 90° bridge, when the two first adjustment submodules are in different on/off states, the second radio frequency output port outputs no signal; and when the two first adjustment submodules are in a same on/off state, the second radio frequency output port outputs a signal.

16. The radio frequency module according to claim 14 or 15, wherein each of the two first adjustment submodules comprises a first adjustment stub, a first diode, a first capacitor, a first inductor, and a first control end;
the first adjustment stub, the first diode, and the first capacitor are sequentially connected, the first adjustment stub is connected to an output end of the bridge, and the first capacitor is grounded;
the first diode is connected to the first inductor, and the first inductor is connected to the first control end; and
the first control end is configured to control an on/off state of the first diode.

17. The radio frequency module according to claim 14 or 15, wherein each of the two first adjustment submodules comprises a first adjustment stub, a first electric control component, and a first control end that are sequentially connected; and
the first electric control component is grounded, and the first control end is configured to control an on/off state of the first electric control component.

18. The radio frequency module according to any one of claims 12 to 17, wherein the impedance adjustment network comprises a second diode, a second adjustment stub, a second capacitor, a second inductor, and a second control end;
the second diode, the second adjustment stub, and the second capacitor are sequentially connected, the second diode is connected to the power division network and the first radio frequency output port, and the second capacitor is grounded;
the second adjustment stub is connected to the second inductor, and the second inductor is connected to the second control end; and
the second control end is configured to control on/off of the second diode, wherein impedance of the impedance adjustment network in a case in which the second diode is turned on is greater than impedance of the impedance adjustment network in a case in which the second diode is turned off.

19. The radio frequency module according to any one of claims 12 to 17, wherein the impedance adjustment network comprises a second electric control component, a third control end, and a second adjustment stub;
the second electric control component is connected to the power division network, the first radio frequency output port, the third control end, and the second adjustment stub, and the second adjustment stub is grounded; and
the third control end is configured to control on/off of the second electric control component, wherein impedance of the impedance adjustment network in a case in which the second electric control component is turned on is greater than impedance of the impedance adjustment network in a case in which the second electric control component is turned off.

20. The radio frequency module according to any one of claims 12, 14, 18, and 19, wherein the phase-shift filtering network comprises a filtering subnetwork and a phase-shift subnetwork;
the power division network is connected to the filtering subnetwork and the phase-shift subnetwork, and the phase-shift subnetwork is connected to the second radio frequency output port; and
when the filtering subnetwork is turned off, the second radio frequency output port outputs a signal; and when the filtering subnetwork is turned on, the second radio frequency output port outputs no signal.

21. The radio frequency module according to claim 20, wherein the filtering subnetwork comprises a third adjustment stub, a third diode, a third capacitor, a third inductor, and a fourth control end;
the third adjustment stub, the third diode, and the third capacitor are sequentially connected, the third adjustment stub is connected to the power division network, and the third capacitor is grounded;
the third diode is connected to the third inductor, and the third inductor is connected to the fourth control end; and
the fourth control end is configured to control an on/off state of the third diode.

22. The radio frequency module according to claim 20, wherein the phase-shift subnetwork comprises a 90° bridge, two second adjustment submodules, and a fifth control end;
an input end of the 90° bridge is connected to the filtering subnetwork and the power division network, and three output ends of the 90° bridge are respectively connected to the two second adjustment submodules and the second radio frequency output port; and
the fifth control end is configured to control on/off states of the two second adjustment submodules.

23. An antenna apparatus, comprising a feeding network, wherein the feeding network comprises the radio frequency module according to any one of claims 1 to 22.

24. A communication device, comprising the antenna apparatus according to claim 23.
